# EUROPÄISCHE PATENTSCHRIFT

(11) **EP 1 616 222 B1**
(45) Veröffentlichungstag und Bekanntmachung des Hinweises auf die Patenterteilung: **21.03.2007**
(21) Anmeldenummer: 04728345.2
(22) Anmeldetag: 20.04.2004
(51) Int. Cl.: G03F 1/00

(54) **ANORDNUNG ZUR INSPEKTION VON MASKEN IN DER MIKROLITHOGRAPHIE**
ARRANGEMENT FOR INSPECTING MASKS IN MICROLITHOGRAPHY
SYSTEME POUR INSPECTER DES MASQUES EN MICROLITHOGRAPHIE

(30) Priorität: 24.04.2003 DE 10318560
(43) Veröffentlichungstag der Anmeldung: 18.01.2006
(73) Patentinhaber: Carl Zeiss SMS GmbH, 07745 Jena (DE)
(72) Erfinder: DOBSCHAL, Hans-Jürgen, 99510 Kleinromstedt (DE); HARNISCH, Wolfgang, 07778 Lehesten (DE); SCHERÜBL, Thomas, 07745 Jena (DE); ROSENKRANZ, Norbert, 07629 Reichenbach (DE); SEMMLER, Ralph, 07745 Jena (DE)
(74) Vertreter: Hampe, Holger
(86) Internationale Anmeldenummer: PCT/EP2004/004161
(87) Internationale Veröffentlichungsnummer: WO 2004/095136

(56) Entgegenhaltungen:
- EP-A- 1 063 676
- US-A- 3 917 950
- US-A- 5 498 923
- IMADA S ET AL: "EPITAXIAL GROWTH OF FERROELECTRIC YMNO3 THIN FILMS ON SI (111) SUBSTRATES BY MOLECULAR BEAM EPITAXY" JAPANESE JOURNAL OF APPLIED PHYSICS, PUBLICATION OFFICE JAPANESE JOURNAL OF APPLIED PHYSICS. TOKYO, JP, Bd. 37, Nr. 12A, PART 1, Dezember 1998 (1998-12), Seiten 6497-6501, XP000927318 ISSN: 0021-4922

## Beschreibung

Zur Beobachtung von Objekten oder Abbildungen von Objekten, die sich in Vakuumkammern befinden ist es erforderlich entweder die Beobachtungsoptik und den Sensor(Kamera) in die Vakuumkammer einzubringen, oder die Beobachtung durch ein Vakuumfenster hindurch auszuführen.

### Stand der Technik

Dies ist insbesondere erforderlich bei Abbildungen mittels extremer ultravioletter Strahlung (EUV), wenn diese Strahlung mittels Scintillatoren in Strahlung anderer Wellenlänge gewandelt wird und dann mittels weiterer Optiken auf den Sensor abgebildet wird (US 5498923).

Von T. Haga und anderen wurde in [1] ein Lösung zur Kontrolle von Lithographiemasken mit extrem ultravioletter Strahlung beschrieben, die die Verwendung eines Interferenz-Mikroskops nach "Mirau" vorsieht. Anhand von Masken mit programmierten Defekten wurde nachgewiesen, dass mit dieser Lösung verschiedene Masken direkt untersucht und Defekte sicher detektiert werden können.

Befindet sich der Sensor im Inneren der Kammer so führt das zu Ausgasungen von zum Beispiel Siloxanen oder Kohlenwasserstoffen aus dem Sensor. Dies erzeugt ein hohes Risiko von Kontaminationen auf den in der Kammer befindlichen Einrichtungen. Besonders gefährdet sind dabei optische Elemente die energiereicher Strahlung, insbesondere EUV Strahlung ausgesetzt sind.

Befindet sich der Sensor außerhalb der Kammer, muss die zur Abbildung benutzte Strahlung durch ein Vakuumfenster hindurch auf den Sensor geleitet werden. In diesem Falle ergeben sich durch das Fenster selbst Einschränkungen hinsichtlich Qualität der optischen Abbildung und nutzbarer Apertur der Abbildungsoptik.

### Literatur:

[1] Haga T. et al., "At-wavelength extreme ultraviolet lithography mask inspection using a Mirau interferometric microscope", J. Sci. Technol. B, Vol. 18, Jahrgang 200, 2916-2920

### Erfinderische Lösung:

Erfindungsgemäß wird dieses Problem gelöst, indem der Scintillator selbst das Fenster bildet oder die vor dem Sensor befindliche Abbildungsoptik so ausgebildet wird, dass sie oder ein Teil von ihr das Vakuumfenster bildet.

Dabei sind verschiedene Konfigurationen in Abhängigkeit von der jeweiligen Aufgabenstellung möglich.
a) das abbildende Objektiv ist vakuumdicht und bildet das eigentliche Fenster
b) der Scintillator bildet das Vakuumfenster. Dieses ist dann vorteilhaft auswechselbar ausgestaltet, wenn ein Alterungsvorgang des Scintillators einsetzt.
c) ein Teil des Objektivs bildet das Vakuumfenster. Hier ist insbesondere vorteilhaft, die von der Strahlungsquelle aus erste Linse der Abbildungsoptik als Vakuumfenster auszubilden, weil die übrigen Objektivteile dann nicht dem Vakuum ausgesetzt sind. Weiterhin kann dann die erste Linse an der Vakuumkammer fest angeordnet sein und der Rest des Objektivs auswechselbar, um die Abbildungsbedingungen, beispielsweise zur Aufnahme eines Übersichtsbildes, durch den Ansatz anderer Linsengruppen, zu verändern

### Aufgabenstellung

Mit allen aufgeführten Varianten wird erreicht, das sich der eigentliche Sensor, welcher ein hohes Risiko bezüglich Ausgasen und Kontamination darstellt außerhalb der Vakuumkammer angeordnet werden kann und trotzdem eine hohe optische Abbildungsgüte möglich ist.

### Ausführungsbeispiel

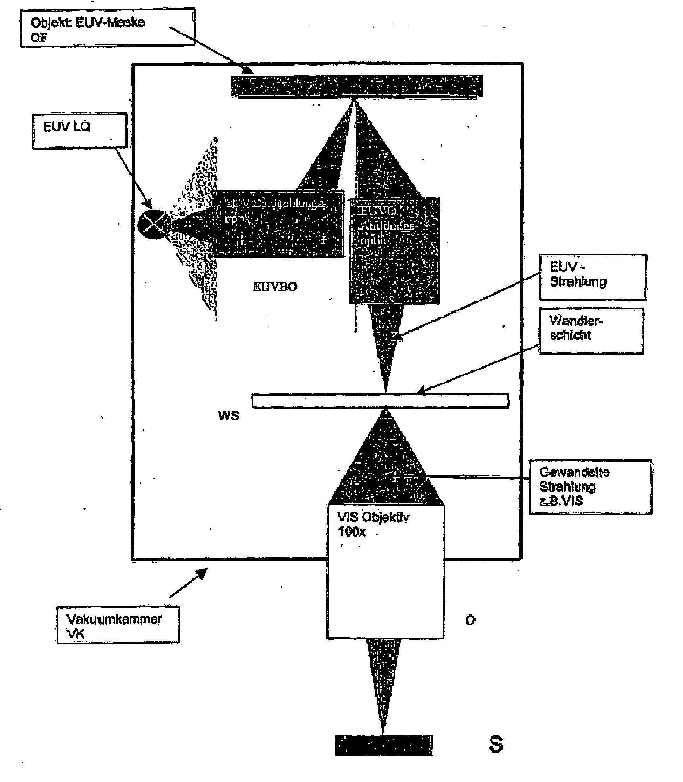

Die Erfindung wird anhand Fig. 1 näher erläutert. Die Anordnung zur Inspektion von Masken in der Mikrolithographie besteht-aus einer EUV-Lichtquelle EUVLQ, einer EUV-Beleuchtungsoptik EUVBO, einer EUV-Abbildungsoptik EUVO einem als Wandlerschicht dienenden Scintillator WS zur Umwandlung der vom Objektfeld OF kommenden Beleuchtungsstrahlung in eine Strahlung größerer Wellenlänge, einem Abbildungsobjektiv O sowie einem Sensor (S) zur Bildaufzeichnung, wobei der Sensor außerhalb einer Vakuumkammer VK angeordnet ist. Als optische Schnittstelle von der Vakuumkammer VK zum Sensor S dient die Wandlerschicht WS oder zumindest ein Teil eines Abbildungsobjektivs O als Fenster in der Vakuumkammer.

Das mit einer Lichtquelle EUVLQ über eine Beleuchtungsoptik EUVBO beleuchtete Objektfeld OF wird mittels einer EUV Optik EUVBO auf einen Scintillator S abgebildet. Der Scintillator wandelt das Bild im EUV Wellenlängenbereich in ein Bild im längerwelligen Bereich welches mit einem Abbildungsobjektiv O (z. B. Mikroobjektiv) dann auf den Sensor abgebildet wird. Dabei wird das Abbildungsobjektiv/der Scintillator erfindungsgemäß in einer der oben beschriebenen Konfigurationen benutzt.

Das Objektiv O ist schematisch dargestellt, es kann ein erstes optisches Glied das Fenster bilden dem außerhalb der Vakuumkammer VK angeordnete, hier nicht dargestellte weitere Linsenglieder, folgen.

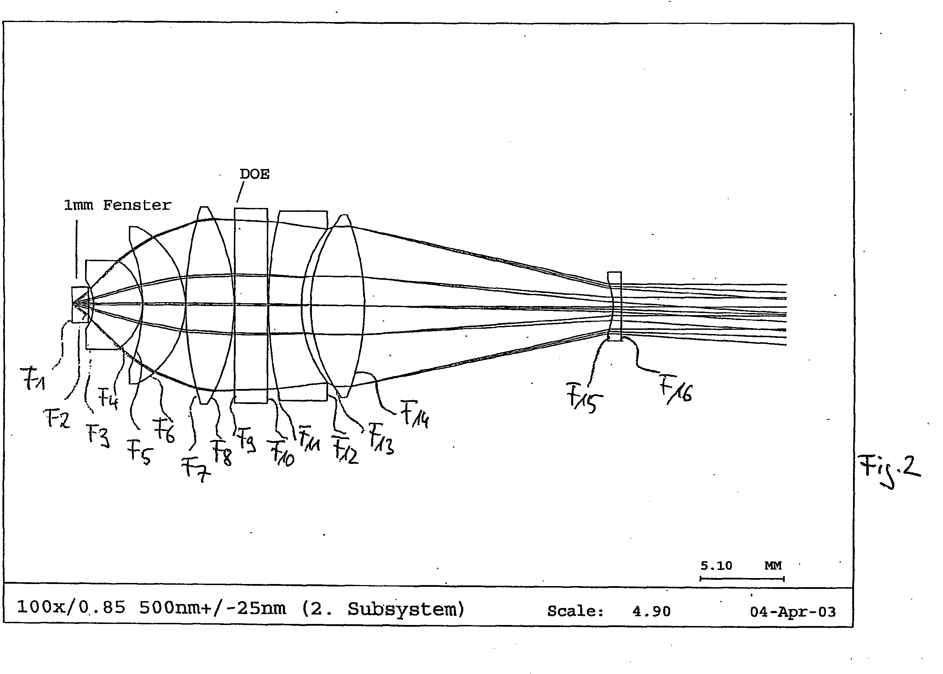

In Fig. 2 ist ein optisches Beispiel für das Objektiv O angegeben.

Es handelt sich vorteilhaft um ein kittfreies Hybridobjektiv, wie es in DE 10130212 A1 ausführlich beschrieben ist. Dieses hat den Vorteil geringeren Materialaufwandes und besserer optischer Qualität.

Mit einem diffraktiven Element DOE erfolgt eine Brechungsverstärkung und Achromatisierung.

Das erste optische Glied F1/F2 kann hier das Fenster der Vakuumkammer sein, aber beispielsweise auch das DOE F9/F10.

| **Daten des Hybridobjektives (mm)** | | | |
|---|---|---|---|
| Fläche | Radius | Dicke | Material |
| F1 | Unendlich | | |
| | | 1.000 | Q1 (sytn. Quarz) |
| F2 | Unendlich | | |
| | | 0.3028 | Luft |
| F3 | -2.744 | | |
| | | 2.9773 | Bk10 |
| F4 | -3.116 | | |
| | | 0.0200 | Luft |
| F5 | -9.911 | | |
| | | 2.5723 | Bk7 |
| F6 | -5.292 | | |
| | | 0.0500 | Luft |
| F7 | 19.699 | | |
| | | 2.9207 | Bk7 |
| F8 | -11.828 | | |
| | | 0.0500 | Luft |
| F9 | Unendlich | | |
| | | 2.0033 | Bk7 |
| F10 | Unendlich | | |
| | | | |
| F11 | 23.072 | | |
| | | 2.0000 | Nsf6 |
| F12 | 7.541 | | |
| | | 0.5624 | Luft |
| F13 | 9.051 | | |
| | | 3.2297 | Psk53a |
| F14 | -15.148 | | |
| | | 15.2701 | Luft |
| F15 | -4.369 | | |
| | | 0.500 | Ssk2 |
| F16 | -117.556 | | |

.....weiter zur Tubuslinse (nicht dargestellt)

## Patentansprüche

1. Anordnung zur Inspektion von Masken in der Mikrolithographie, bestehend aus einer EUV-Lichtquelle (EUVLQ), einer EUV-Beleuchtungsoptik (EUVBO), einer EUV-Abbildungsoptik (***EUVO***) einer Wandlerschicht (***WS***) zur Umwandlung der vom Objektfeld (***OF***) kommenden Beleuchtungsstrahlung in eine Strahlung größerer Wellenlänge, einem Abbildungsobjektiv (***O***) sowie einem Sensor (***S***) zur Bildaufzeichnung, **dadurch gekennzeichnet, dass** der Sensor (***S***) außerhalb einer Vakuumkammer (***VK***) angeordnet ist und als optische Schnittstelle von der Vakuumkammer (***VK***) zum Sensor (***S***) die Wandlerschicht (***WS***) oder zumindest ein Teil eines Abbildungsobjektivs (*O*) als Fenster in der Vakuumkammer ausgebildet ist.

2. Anordnung nach Anspruch 1, ***dadurch gekennzeichnet, dass*** das Abbildungsobjektiv **(*O*)** ein kittfreies Hybridobjektiv mit mindestens einem diffraktiven Element (DOE) ist.

3. Anordnung nach Anspruch 2, ***dadurch gekennzeichnet, dass*** eine erste Optikgruppe mit positiver Brechkraft und eine der ersten Optikgruppe nachgeschaltete zweite Optikgruppe mit negativer Brechkraft vorgesehen sind und die erste Optikgruppe das (DOE) enthält.

## Claims

1. Arrangement for the inspection of masks in microlithography, consisting of an EUV-light source (EUVLQ), EUV-illumination optics (EUVBO), EUV-imaging optics (EUVO) a converter layer (WS) for converting the illumination radiation emanating from the object field (OF) into radiation with a longer wavelength, an imaging objective (O) and a sensor (S) for recording images, **characterised in that** the sensor (S) is disposed outside a vacuum chamber (VK) and the optical interface from the vacuum chamber (VK) to the sensor (S) is formed by the converter layer (WS) or at least a part of an imaging objective (O) as a window in the vacuum chamber.

2. Arrangement as claimed in claim 1, **characterised in that** the imaging objective (O) is a cement-free hybrid objective having at least one diffractive element (DOE).

3. Arrangement as claimed in claim 2, **characterised in that** a first optics group which has a positive refractive power and a second optics group which has a negative refractive power and is connected downstream of the first optics group are provided and the first optics group contains the (DOE).

## Revendications

1. Dispositif pour l'inspection de masques en microlithographie, consistant en une source de lumière EUV (EUVLQ), une optique d'éclairage EUV (EUVBO), une optique d'imagerie EUV (EUVO), une couche de conversion (WS) pour la conversion du rayonnement d'éclairage venant du champ objet (OF) en un rayonnement de longueur d'onde plus grande, un objectif d'imagerie (O) ainsi qu'un capteur (S) pour l'enregistrement de l'image, **caractérisé en ce que** le capteur (S) est disposé en dehors d'une chambre à vide (VK) et **en ce que**, comme interface optique de la chambre à vide (VK) au capteur (S), la couche de conversion (WS) ou au moins une partie d'un objectif d'imagerie (O) sont configurées comme fenêtre dans la chambre à vide.

2. Dispositif selon la revendication 1, **caractérisé en ce que** l'objectif d'imagerie (O) est un objectif hybride sans mastic avec au moins un élément diffracteur (DOE).

3. Procédé selon la revendication 2, **caractérisé en ce qu'**un premier groupe optique avec une force de réfraction positive et un deuxième groupe optique en aval avec une force de réfraction négative sont prévus, et **en ce que** le premier groupe optique contient le (DOE).
